Europäisches Patentamt

European Patent Office

Office européen des brevets

(11) Publication number: **0 410 705 A2**

# EUROPEAN PATENT APPLICATION

(21) Application number: 90308115.6

(22) Date of filing: 25.07.90

(51) Int. Cl.5: **H04B 1/18**, H03H 7/38, H01Q 1/12

(30) Priority: 28.07.89 GB 8917362

(43) Date of publication of application:
30.01.91 Bulletin 91/05

(84) Designated Contracting States:
AT BE CH DE DK ES FR GB GR IT LI LU NL SE

(71) Applicant: THE GENERAL ELECTRIC
COMPANY, p.l.c.
1 Stanhope Gate
London W1A 1EH(GB)

(72) Inventor: Davies, John
Flat 2, 472 Manchester Road, Heaton Chapel
Stockport, Cheshire SK4 5OL(GB)

(74) Representative: Pope, Michael Bertram
Wingate
The General Electric Company, p.l.c., GEC
Patent Dept.(Wembley Office), Hirst
Research Centre, East Lane
Wembley Middlesex HA9 7PP(GB)

(54) Vehicle radio receiver systems.

(57) A vehicle radio receiver system comprising: an antenna (1) comprising a rear window electric heater of the vehicle; a receiver (17); a cable (15) connecting the antenna (1) to the receiver (17); and a matching circuit (25) between the antenna (1) and the cable (15). Two elements of the matching circuit are constituted by the capacitance ($C_4$) of the antenna (1) to ground and the capacitance ($C_6$) of the cable (15) to ground respectively. The matching circuit (25) is arranged to have input and output resistances substantially matching the output resistance ($R_1$) of the antenna (1) and the input resistance ($R_2$) of the receiver (17) respectively and a transfer function T(f) where f is frequency, such that $V_1$ (f).T(f) = k = $V_2$(f), for the frequency range 100 to 2000 KHz, where $V_1$ is the voltage from the antenna (1), k is a constant and $V_2$ the voltage developed at the input to the receiver (17).

Fig. 2.

EP 0 410 705 A2

# VEHICLE RADIO RECEIVER SYSTEMS

This invention relates to vehicle radio receiver systems.

More particularly the invention relates to such systems comprising: an antenna; a receiver; cable means for connecting the antenna to the receiver; and a matching circuit between said antenna and said cable means.

In such a system the matching circuit is, of course, designed to improve power transference from the antenna to the receiver. However, where, as is often the case in a vehicle, the form of the antenna is dictated by other considerations, e.g. when the antenna is also to be used as a heater for the rear window of the vehicle, it is difficult to design a matching circuit which operates satisfactorily over the whole of a desired waveband.

It is an object of the present invention to provide a vehicle radio receiver system wherein this problem is alleviated.

According to the present invention there is provided a vehicle radio receiver system comprising: an antenna; a receiver; cable means connecting the antenna to the receiver; and a matching circuit between said antenna and said cable means, characterised in that: a reactance of said antenna and a reactance of said cable means constitute elements of said matching circuit; and the matching circuit is arranged to have input and output resistances substantially matching the output resistance of the antenna and the input resistance of the receiver respectively.

One vehicle radio receiver system in accordance with the present invention will now be described, by way of example, with reference to the accompanying drawings, in which:

Figure 1 is a circuit diagram of the system;

Figure 2 is an equivalent circuit diagram of the system; and

Figure 3 is a circuit diagram showing a modification of the system of Figure 1.

The system is a long-wave and medium-wave receiver system in a vehicle and makes use of the rear window electric heater of the vehicle as an antenna.

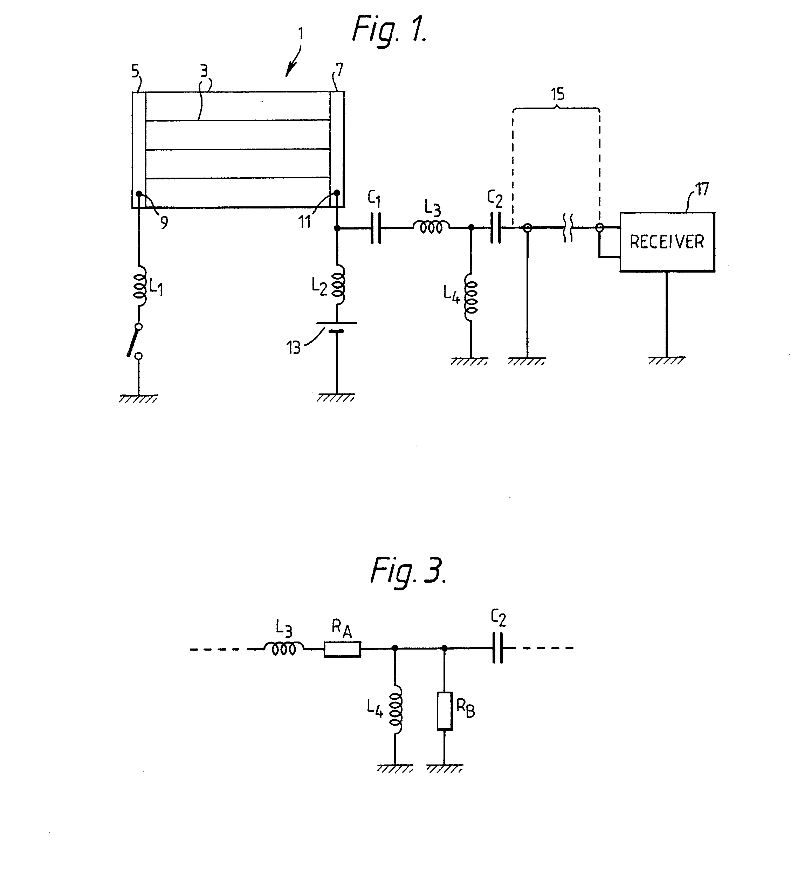

Referring to Figure 1, the antenna 1 of the system comprises an array of parallel spaced resistance heating wires 3 mounted on the vehicle rear window (not shown) and joined at each end by a vertical conductor 5 or 7 of relatively low resistance also mounted on the window.

Terminals 9 and 11 are connected via radio frequency isolation inductors $L_1, L_2$ to the vehicle battery 13 for the supply of electric current to the wires 3 for heating purposes, one terminal of the battery being connected to the vehicle chassis in conventional manner.

For use of the wires 3 and conductors 5,7 as a radio antenna, the terminal 11 is connected via capacitors $C_1$ and $C_2$ and an inductor $L_3$, connected in series as shown in Figure 1, to the inner conductor of a coaxial cable 15. At its other end the inner conductor of the cable 15 is connected to the antenna terminal of a radio receiver 17, the outer conductor of the cable 15 being connected to the vehicle chassis. An inductor $L_4$ is connected between the junction between inductor $L_3$ and capacitor $C_2$ and the vehicle chassis.

The capacitor $C_1$ serves as a d.c. blocking capacitor. The inductors $L_1$ and $L_2$ serve as radio frequency chokes to isolate the antenna 1 from ground, i.e. the vehicle chassis and bodywork. In addition, the capacitor $C_1$ and inductors $L_1$ and $L_2$, together with capacitor $C_2$ and inductors $L_3$ and $L_4$ and reactive elements of the antenna 1 and the cable 15, constitute a matching circuit.

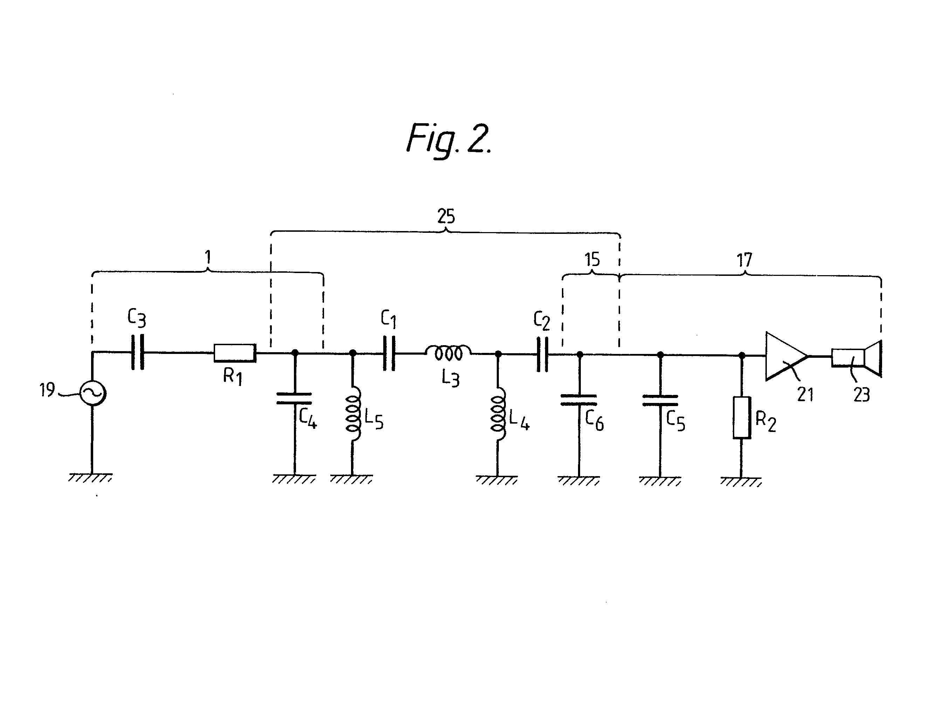

Referring to Figure 2, in the equivalent circuit the following electrical components together represent the antenna 1: an alternating current source 19 which represents an alternating current signal produced by the antenna 1, capacitors $C_3$ and $C_4$ which respectively represent the capacitance of the antenna 1 itself and the capacitance of the antenna 1 to ground, and a resistor $R_1$ which represents the resistance of the antenna 1. The input impedance of the receiver 17 is represented by a capacitor $C_5$ and a resistor $R_2$, the rest of the receiver being represented by an amplifier 21 and a loudspeaker 23. A capacitor $C_6$ represents the capacitance to ground of the coaxial cable 15 and an inductor $L_5$ represents the parallel combination of inductors $L_1$ and $L_2$ of Figure 1. The equivalent circuit further includes capacitors $C_1, C_2$ and inductors $L_3, L_4$ of Figure 1.

The matching circuit 25 comprises the electrical components: $C_4, L_5, C_1, L_3, L_4, C_2$ and $C_6$. Thus, reactances of both the antenna 1 and the cable 15 constitute elements of the matching circuit 25. Ideally, the matching circuit 25 is designed so that the circuit 25 terminates at the antenna-side in a resistance equal to the antenna resistance $R_1$ and a reactance equal to the conjugate of the antenna capacitance $C_3$, and at the coaxial cable-side in a resistance equal to the receiver resistance $R_2$ and a reactance equal to the conjugate of the receiver input capacitance $C_5$. Further, the matching circuit is designed so that the transfer function, T(f) where f is frequency, of the circuit 25 is such that:

$$V_1(f) \cdot T(f) = k = V_2(f) \qquad (1),$$

for all frequencies within the long-wave and medium-wave bands, where $V_1$ is the voltage from the antenna 1, k is a constant and $V_2$ the voltage developed at the input to the receiver 17.

As is well-known, the extent to which the design intent can be achieved is inversely related to the range of frequencies over which the network is required to operate.

In one particular embodiment of the system of Figure 1, for use over the frequency range 100-1000 KHz, the values of the components of the equivalent circuit of Figure 2 are as follows:
$R_1 = 1600$ , $R_2 = 2700$ , $C_1 = 390pF$, $C_2 = 0.1$ F,
$C_3 = 30pF$, $C_4 = 50pF$, $C_5 = 8pF$, $C_6 = 100pF$,
$L_3 = 150$ H, $L_4 = 1mH$ and $L_5 = 1.2mH$.

Referring to Figure 3, resistors $R_A$ and $R_B$ can be added to the matching circuit of the system of Figure 1 as shown in Figure 3 for the purpose of the control of the Q values of inductors $L_3$ and $L_4$. Such control adjusts the frequency response of the system and can thus be used to compensate for variations in the efficiency of the antenna 1 with frequency.

It is to be appreciated that the invention is not only applicable where the vehicle antenna is the rear window electric heater, but is applicable in any circumstances where the impedance of the vehicle antenna is dependent on the disposition of the antenna in the vehicle. For example, the invention is also applicable where the antenna comprises an electrical conductor which is bonded to a nonconducting reinforced plastic vehicle body panel.

It is also to be appreciated that a system in accordance with the invention need not be designed to operate over the long-wave and medium-wave bands, but that another range of wavelengths may be selected. The principle of the invention resides in the incorporation of a reactance of the antenna and a reactance of the cable in the matching circuit, other electrical elements of the matching circuit being chosen dependent on the selected frequency range of operation of the system, and the required matching.

## Claims

1. A vehicle radio receiver system comprising: an antenna (1); a receiver (17); cable means (15) connecting the antenna (1) to the receiver (17); and a matching circuit (25) between said antenna (1) and said cable means (15), characterised in that: a reactance ($C_4$) of said antenna (1) and a reactance (C₆) of said cable means (15) constitute elements of said matching circuit (25); and the matching circuit (25) is arranged to have input and output resistances substantially matching the output resistance ($R_1$) of the antenna (1) and the input resistance ($R_2$) of the receiver (17) respectively.

2. A system according to Claim 1 wherein said matching circuit (25) has a transfer function, T(f) where f is frequency, such that:
$V_1(f).T(f) = k = V_2(f),$
for all frequencies within a selected frequency band, where $V_1$ is the voltage from said antenna (1), k is a constant and $V_2$ the voltage developed at the input to said receiver (17).

3. A system according to Claim 2 wherein said selected frequency band is 100 to 2000 KHz.

4. A system according to Claim 1 or Claim 2 or Claim 3 wherein said reactance ($C_4$) of said antenna (1) is the capacitance ($C_4$) of said antenna to ground and said reactance ($C_6$) of said cable means (15) is the capacitance ($C_6$) of said cable means (15) to ground.

5. A system according to any one of the preceding claims wherein said matching circuit (25) includes a series inductor ($L_3$).

6. A system according to Claim 5 wherein said matching circuit (25) includes a resistor ($R_A$) in series with said series inductor ($L_3$).

7. A system according to any one of the preceding claims wherein said matching circuit (25) includes a parallel inductor ($L_4$).

8. A system according to Claim 7 wherein said matching circuit (25) includes a resistor ($R_B$) in parallel with said parallel inductor ($L_4$).

9. A system according to any one of the preceding claims wherein said antenna (1) comprises a rear window electric heater of the vehicle.

10. A system according to Claim 9 wherein said matching circuit (25) includes at least one radio frequency isolation inductor ($L_1$, $L_2$) via which said rear window electric heater is connected to the vehicle battery (13) for the supply of electric current for heating purposes.

11. A system according to Claim 9 or Claim 10 wherein said matching circuit (25) includes at least one capacitor ($C_1$) which serves to prevent direct current from the vehicle battery (13) reaching said receiver (17).

Fig. 1.

Fig. 3.

4

Fig. 2.